(19) Europäisches Patentamt
European Patent Office
Office européen des brevets

(11) Publication number: **0 058 214**
**B1**

(12) **EUROPEAN PATENT SPECIFICATION**

(45) Date of publication of patent specification: **19.06.85**

(51) Int. Cl.[4]: **C 23 F 1/00,** C 23 C 8/04, H 01 L 21/306, H 01 L 21/465 // G03F7/02, G03F7/26

(21) Application number: **81101073.5**

(22) Date of filing: **16.02.81**

# (54) Method for increasing the resistance of a solid material surface against etching.

(43) Date of publication of application:
**25.08.82 Bulletin 82/34**

(45) Publication of the grant of the patent:
**19.06.85 Bulletin 85/25**

(84) Designated Contracting States:
**DE FR GB**

(56) References cited:
**EP-A-0 007 108**

**PATENT ABSTRACTS OF JAPAN, unexamined applications, C-section, vol. 3, no. 83, July 18, 1979 THE PATENT OFFICE JAPANESE GOVERNMENT PAGE 86 C 52**

**PATENT ABSTRACTS OF JAPAN, unexamined application, C-section, vol. 3, no. 83, July 18, 1979 THE PATENT OFFICE JAPANESE GOVERNMENT page 87 C 52**

**PATENT ABSTRACTS OF JAPAN, unexamined applications, C-section, vol. 2, no. 93, July 29, 1978 THE PATENT OFFICE JAPANESE GOVERNMENT PAGE 1644 C 78**

(73) Proprietor: **International Business Machines Corporation**
**Old Orchard Road**
**Armonk, N.Y. 10504 (US)**

(72) Inventor: **Dätwyler, Kurt**
**Reidholzstrasse 58**
**CH-8805 Richterswil (CH)**
Inventor: **Oosenbrug, Albertus**
**Schwandelstrasse 26A**
**CH-8800 Thalwil (CH)**

(74) Representative: **Schröder, Otto, Dr. Ing.**
**Säumerstrasse 4**
**CH-8803 Rüschlikon (CH)**

(56) References cited:
**PATENT ABSTRACTS OF JAPAN, unexamined applications, C-section, vol. 1, no. 111, September 26, 1977 THE PATENT OFFICE JAPANESE GOVERNMENT page 2628 C 77**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 058 214 B1

**Description**

The invention concerns a method for selectively etching a metal film deposited on a substrate. The method may, for example, be employed in the process of fabricating masks for use in integrated circuit manufacturing.

Etch processes are widely used. A particularly important application is in the manufacturing of semi-conductor and Josephson junction devices or integrated circuits. In combination with photolithographic processes they can be employed to pattern a structure, e.g., by selectively etching zones of a metal film thereby leaving the desired pattern on the substrate supporting the film. A more specific application is in the fabrication of metal masks that are in turn used in photolithographic processes.

In order to achieve selective etching numerous methods have been developed, such as those that employ photoresist stencils for pattern definition. Representative of the state of the art is the etching method described in "Patent Abstracts of Japan", Vol. 3, No. 83, July 18, 79, page 87 C 52 (Kokai—No. 54—60237). In that method, the surface of the material to be etched, e.g. Al, is completely covered with a thin nitride film which is then patterned in a plasma etching step using, e.g., $CF_4$. Subsequently, a dry etching process is used to etch the Al whereby the thin film serves as a mask that is resistant to the etchant employed.

More recently, a basically different process has been proposed in EP—A—0021095 which provides for image reversal and is particularly useful in the fabrication of low-coverage patterns. This process includes an additional step by which a metal coating is applied to the surface regions of the metal film that are to form the desired pattern, i.e., regions that are not to be etched off in a subsequent etching step.

This latter process, involving the deposition of a non-native etch resistant metal layer on the surface of the metal film by an evaporation process, becomes critical, however, for high density patterns with line width below 1 µm and accurate pattern edge definition that are required in today's highly advanced integrated circuit techniques. In order to obtain defect-free patterns, a pin-hole free coverage of the underlying film is needed. This calls for a thickness of the deposited layer of about 0.5 nm which results in less accurate pattern edge definition since it impedes subsequent lift-off of the deposit required in the process. As explained above, this method, furthermore, requires additional process steps. The metal layer is to be deposited and, after removal from the vacuum chamber, a lift-off operation is needed that becomes increasingly critical with increasing thickness of the deposited metal layer.

The invention as claimed is intended to remedy these drawbacks.

The main advantage offered by the invention is that the method permits the fabrication of high precision patterns with accurate edge definition. The process is, furthermore, simple in that the chemical treatment and the subsequent resist removal step can take place in the same vacuum.

Furthermore, the new method is not critical in that process parameters can reliably be controlled to avoid attacking of the photoresist stencils as well as undesirable etching of the material to be covered by the native surface layer. Other parameters, such as process temperature, are non-detrimental to the structures produced.

The method also permits image reversal especially of interest for low coverage patterns where the e-beam writing time can be substantially reduced when high resolution positive photoresists are used.

The inventive method can advantageously be used in the fabrication of metal masks. Such masks, consisting of a patterned metal film supported by a glass substrate, are being used in the photolithographic steps employed in the fabrication of, e.g., semiconductor or Josephson junction devices and, more particular, in the fabrication of integrated circuits.

One way of carrying out the invention is described in detail below with reference to drawings which represent only one specific embodiment and in which Fig. 1A through E illustrate the process steps involved in the production of a metal mask.

Briefly, the mask fabrication process in accordance with the invention involves the following steps: initially a glass plate coated with a metal film is provided. After application of a positive high resolution photoresist, the resist is exposed, e.g., by an e-beam writing the desired mask pattern, and developed. Subsequently the exposed resist is removed in a conventional manner. Then the plate is subjected to a gas discharge plasma treatment during which a thin native surface layer is formed at the surface of the exposed metal film. This layer is highly etch resistant against the metal etchant later on used during the process after the remaining resist has been removed.

Contrary to conventional photoresist techniques, the process leads to an image reversal. The resulting metal film pattern corresponds to the light or e-beam pattern to which the photoresist-covered plate is exposed whereas conventional techniques result in metal patterns corresponding to the zones that had not been exposed.

When e-beam techniques are used in high precision applications, the image reversal method substantially reduces the required e-beam writing time for low coverage patterns that are frequently needed in electronic device applications.

With the aid of the figures the inventive method will now be described in more detail. Fig. 1A shows a glass substrate 1 coated with a thin chromium film 2 that is to be patterned. This film has a thickness of at least 30 nm, preferably 50 to 100 nm. A photoresist layer 3 is applied in a conventional manner on top of the metal film 2. A positive resist is used such as Shipley AZ-1350 (Trademark of Shipley Company, Inc.). The photoresist is then exposed to an e-beam pattern, a section of which is illustrated by the arrows 4. Optical methods may of course also be employed to expose the photoresist to the desired pattern.

After removal of the exposed resist the structure shown in Fig. 1B is obtained. The substrate is then placed into a conventional plasma etching chamber where it is exposed to a $CF_4$ plasma treatment, the plasma containing approx. 5% $O_2$. With the following process parameters the plasma treatment has yielded the desired formation of the etchant-resistant layer: pressure—70 Pa, RF power—0,4 $W/cm^2$, RF voltage—280 V peak to peak, temperature—20°C, duration of plasma treatment—at least 20 minutes.

During the plasma treatment a thin etchant-resistant $CrF_2$ layer 5, shown in Fig. 1C, is formed on the chromium film. It is a native layer, i.e., a chemical compound with the chromium and the reactive species of the plasma, in this case fluorine, as constituents.

The remaining photoresist is then stripped off. This results in the structure of Fig. 1D with the region of the chromium film that corresponds to the pattern written by the e-beam 4 covered by the layer 5. This layer proved to be very resistant against the etchant used in the next process step during which the chromium is etched in regions 6. The etch solution used:

$$CH_3COOH+Ce(NH_4)_2(NO_3)_6$$

in deionized water.

In this solution it takes typically 0,5 minutes to etch through 30 nm of unprotected chromium. It has been observed that the etch resistant layer 5 obtained by the plasma treatment described above causes an etch "incubation" time of 3 to 4 minutes, i.e., chromium film 2 is protected for this period of time before it is being etched at approx. the normal etch rate. The etch time ratio of approx. 7 is sufficiently high to guarantee selective etching and thus high contrast chromium patterns.

After etching for about 2 minutes the structure shown in Fig. 1E is obtained.

The processing conditions during the chemical treatment must be such that the material of film 2 is not etched off and that no surplus material deposition takes place. Also, the photoresist mask must not be effected by the treatment. The above described process meets these requirements completely satisfactorily.

The application of the inventive method is by no means restricted to the specific materials and process conditions used in the example.

The material on which the etch resistant layer is to be formed may consist of metals other than chromium such as aluminium, copper or silver. The main qualification for the material being that during the chemical treatment a layer of a compound thereof is formed that is etch resistant.

Equally, the chemical treatment applicable is not restricted to the $CF_4$ plasma process described above. The treatment can also be in a liquid or in a vapour. For a plasma treatment the reactive species can be nitrogen, carbon, fluorine, chlorium, oxygen—these materials being cited only as examples. The species chosen, together with the material the surface of which is to be made etch resistant, must form the desired etch resistant layer.

With the above described $CF_4$ plasma treatment it has been observed that the etch "incubation" time and thus the resulting resistance against wet chemical etching is enhanced by adding a small amount of oxygen to the $CF_4$ plasma. This effect may be explained by the mechanism of the plasma chemistry: the $CF_4$ molecules will dissociatively absorb at the chromium surface by forming fluorine and carbon atoms as dissociation products. The fluorine atoms will react with the chromium by forming $CrF_2$. However, the carbon will cover the chromium film as an absorbed layer, impeding further formation of $CrF_2$. The addition of oxygen will result in the formation of CO and $CO_2$ as volatile products and, in turn, will clean the chromium surface from absorbed carbon. The addition of $O_2$ to the $CF_4$ plasma will thus result in an enhancement of the formation rate of $CrF_2$. It is, however, expected that exposure to a pure (100%) $CF_4$ plasma during an extended period of time will yield the same result.

The composition of the etch resistant layer naturally depends on the materials and reactive species used. Among others it can be a nitride, carbide, fluoride, chloride, or oxide. A few more specific examples besides the above cited $CrF_2$ are: $Al_4C_3$, $AlF_3$, CuF, $CuF_2$, AgF.

The etchants against which the surface layer provides a protection also depend on the materials and processes used, the earlier mentioned

$$CH_3COOH+Ce(NH_4)_2(NO_3)_6$$

in deion. $H_2O$ being an example for a chromium etch solution against which $CrF_2$ is highly resistant. A few other examples of resistant layer-etchant combinations are: $Al_4C_3$ is etch resistant against alkali, which may be used to etch Al; $AlF_3$ is resistant against acids and alkalis; CuF is resistant against acids such as HCl.

**Claims**

1. Method for selectively etching a metal film (2) deposited on a substrate (1), which comprises the steps of:

— applying a layer (3) of positive photoresist on the surface of the metal,
— exposing the photoresist to a radiation pattern (4) corresponding to regions not to be etched,
— removing the exposed resist,
— exposing the remaining structure to a chemical treatment by which an etchant-resistant layer (5) of a compound of the metal is

formed on the surface regions not covered by the unexposed photoresist,

— removing the unexposed photoresist that had remained on the surface, and

— etching of the metal at the regions (6) where it is not protected by said etchant-resistant layer (5) using an etchant against which the said etchant-resistant layer is highly resistant.

2. Method as claimed in claim 1, in which the said chemical treatment is carried out in a liquid, a vapour or in a plasma containing the reactive species required to form said etchant-resistant layer.

3. Method as claimed in claim 2, in which one or more of the following reactive species are used: nitrogen, carbon, fluorine, chlorine, oxygen.

4. Method as claimed in claim 1, in which said metal film (2) consists of chromium, aluminium, copper or silver.

5. Method as claimed in claim 1, in which the said etchant-resistant layer (5) consists of a nitride, carbide, fluoride, chloride or oxide.

6. Method as claimed in claim 1, in which a chromium surface is subjected to a $CF_4+O_2$ plasma treatment by which a $CrF_2$ layer is formed that is highly resistant to an etching solution

$$CH_3COOH+Ce(NH_4)_2(NO_3)_6$$

in deionized water.

7. Method as claimed in claim 6, in which the plasma pressure is above 20 Pa.

**Revendications**

1. Procédé de gravure sélective d'une pellicule métallique (2) déposée sur un substrat (1), caractérisé en ce qu'il comprend les étapes de

— application d'une couche (3) de photoréserve positive sur la surface du métal,

— exposition de la photoréserve à un motif de rayonnements (4) correspondant aux régions à ne pas graver,

— élimination de la réserve exposée,

— exposition de la structure restante à un traitement chimique par lequel une couche résistante à la gravure (5) d'un composé du métal se forme sur les régions superficielles non recouvertes de la photoréserve non exposée,

— élimination de la photoréserve non exposée qui était restée sur la surface, et

— gravure du métal sur les régions (6) où il n'est pas protégé par ladite couche résistante à la gravure (5) au moyen d'un agent de gravure vis-à-vis duquel ladite couche résistante à la gravure est hautement résistante.

2. Procédé selon la revendication 1, caractérisé en ce que ledit traitement chimique est réalisé dans un liquide, une vapeur ou un plasma contenant l'espèce réactive nécessaire à la formation de ladite couche résistante à la gravure.

3. Procédé selon la revendication 2, caractérisé en ce que l'on utilise une ou plusieurs des espèces réactives suivantes: azote, carbone, fluor, chlore, oxygène.

4. Procédé selon la revendication 1, caractérisé en ce que ladite pellicule métallique (2) est constituée par du chrome, de l'aluminium, du cuivre ou de l'argent.

5. Procédé selon la revendication 1, caractérisé en ce que ladite couche résistante à la gravure (5) est constituée par un nitrure, un carbure, un fluorure, un chlorure ou un oxyde.

6. Procédé selon la revendication 1, caractérisé en ce que l'on soumet une surface de chrome à un traitement au plasma de $CF_4+O_2$ par lequel il se forme une couche de $CrF_2$ qui est hautement résistante vis-à-vis d'une solution de gravure

$$CH_3COOH+Ce(NH_4)_2(NO_3)_6$$

dans de l'eau dé-ionisée.

7. Procédé selon la revendication 6, caractérisé en ce que la pression du plasma est supérieure à 20 Pa.

**Patentansprüche**

1. Verfahren zum selektiven Aetzen eines auf einem Substrat (1) aufgebrachten Metallfilms (2), das die folgenden Prozesschritte beinhaltet:

— Aufbringen einer Schicht (3) eines positiven Photolacks auf der Metalloberfläche,

— Belichten des Photolacks mit einem Strahlungsmuster (4), das den nicht zu ätzenden Bereichen entspricht,

— Entfernen des belichteten Photolacks,

— Behandeln der verbliebenen Struktur mittels eines chemischen Verfahrens zur Bildung einer ätzresistenten Schicht (5) bestehend aus einer Verbindung des Metalls in den vom unbelichteten Photolack nicht bedeckten Oberflächenbereichen,

— Entfernen des auf der Oberfläche verbliebenen unbelichteten Photolacks, und

— Aetzen des Metalls in den Bereichen (6), in denen es von der ätzresistenten Schicht (5) nicht geschützt ist, durch Anwendung eines Aetzmittels, gegen welches die ätzresistente Schicht in hohem Masse widerstandsfähig ist.

2. Verfahren nach Anspruch 1, in welchem die chemische Behandlung in einer Flüssigkeit, einer Dampfatmosphäre oder in einem Plasma erfolgt, in welchen die zur Bildung der ätzresistenten Schicht erforderlichen reaktiven Materialien enthalten sind.

3. Verfahren nach Anspruch 2, in welchem eins oder mehrere der folgenden reaktiven Materialien verwendet werden: Stickstoff, Kohlenstoff, Fluor, Chlor, Sauerstoff.

4. Verfahren nach Anspruch 1, in welchem der Metallfilm (2) aus Chrom, Aluminium, Kupfer oder Silber besteht.

5. Verfahren nach Anspruch 1, in welchem die

ätzresistente Schicht (5) aus Nitrid, Karbid, Fluorid, Chlorid oder Oxyd besteht.

6. Verfahren nach Anspruch 1, in welchem eine Chromoberfläche einer $CF_4+O_2$ Plasmabehandlung ausgesetzt wird, durch welche eine $CrF_2$-Schicht gebildet wird, die gegenüber einer aus

$$CH_3COOH+Ce(NH_4)_2(NO_3)_6$$

in entionisiertem Wasser bestehenden Aetzlösung hochgrading widerstandsfähig ist.

7. Verfahren nach Anspruch 6, in welchem der Plasmadruck oberhalb von 20 Pa gehalten wird.

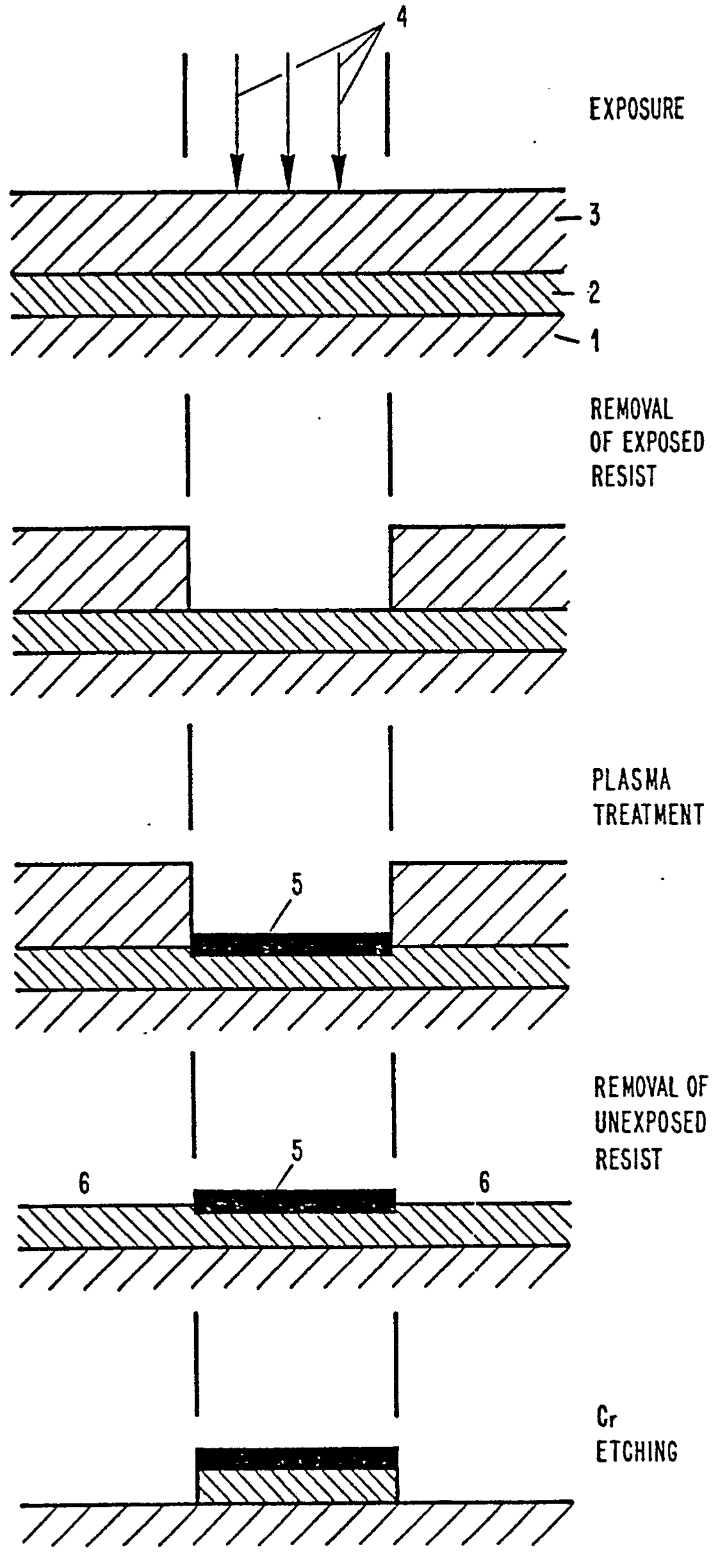


FIG. 1A

FIG. 1B

FIG. 1C

FIG. 1D

FIG. 1E